(19) Europäisches Patentamt
European Patent Office
Office européen des brevets

(11) **EP 4 152 372 A1**

(12) **EUROPEAN PATENT APPLICATION**
published in accordance with Art. 153(4) EPC

(43) Date of publication:
**22.03.2023 Bulletin 2023/12**

(21) Application number: **20935732.6**

(22) Date of filing: **05.06.2020**

(51) International Patent Classification (IPC):
*H01L 23/00* $^{(2006.01)}$

(52) Cooperative Patent Classification (CPC):
**H01L 23/00**

(86) International application number:
**PCT/KR2020/007319**

(87) International publication number:
**WO 2021/230413 (18.11.2021 Gazette 2021/46)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **12.05.2020 KR 20200056539**

(71) Applicant: **An, Seong Ryong
Seoul 05510 (KR)**

(72) Inventor: **An, Seong Ryong
Seoul 05510 (KR)**

(74) Representative: **Mewburn Ellis LLP
Aurora Building
Counterslip
Bristol BS1 6BX (GB)**

(54) **CONDUCTOR BONDING METHOD**

(57) Provided is a conductor bonding method capable of simply and easily performing a conductor bonding operation by placing conductive particle patterns and a conductive particle fixing material directly on lead terminals of an electronic device, the conductor bonding method includes 1) placing a first conductive particle fixing material 110 on lead terminals 2 of an electronic device 1 (S100), 2) forming conductive particle patterns by placing conductive particles 120 in a dense state only on regions, in an upper surface of the first conductive particle fixing material 110, corresponding to the regions where the lead terminals 2 are formed in the electronic device(S200), 3) aligning a conductor (FPCB) 3 on the lead terminals 2 of the display panel 1, on which the first conductive particle fixing material and the conductive particle patterns are formed in step 1) and step 2) (S100-S200) (S300), and 4) bonding the aligned conductor 3 to the lead terminals 2 by applying heat or pressure (S400).

FIG. 14

**Description**

TECHNICAL FIELD

The present disclosure relates to a conductor bonding method, and more particularly, to a conductor bonding method capable of easily and simply performing a bonding operation of a conductor by placing conductive particle patterns and a conductive particle fixing material directly on lead terminals of an electronic device.

RELATED ART

In a display apparatus such as a liquid crystal display (LCD), etc., a driving circuit IC that supplies a voltage to an electric field forming device of each pixel via a signal line has to be mounted around an LCD panel in order to adjust an electric field in each pixel in the apparatus. A driving IC mounting technology, which is a technical method for electrically connecting the liquid crystal panel to the driving IC, is required to have a fine pitch connection, easy connection process, and high reliability according to demands for complicated driving IC, increase in the number of pixels, and high resolution. In order to satisfy the demands for such a driving IC mounting technology, a COG technology of performing a facedown bonding of a bump of the driving IC to an electrode of a liquid crystal panel, for example, an ITO electrode, has been developed.

Although various COG technologies are being introduced by each company, the most common method is a method of thermally attaching and pressing a driving IC having a bump by using an anisotropic conductive film (ACF) and mounting the driving IC on a liquid crystal panel substrate. The anisotropic conductive film has been developed for the past several decades, and the anisotropic conductive film has a structure in which conductive particles are uniformly dispersed mainly in a thermosetting epoxy resin.

As the conductive particles, a polymer or glass ball coated with gold, silver, nickel, or metal of a diameter of about 5 to 20 $\mu$m is usually used. Depending on an amount of conductive particles, a polymer matrix having inherently non-conductive property has anisotropic conductive properties (in the case of 5 to 10 vol%) or isotropic conductive properties (in the case of 25 to 35 vol%).

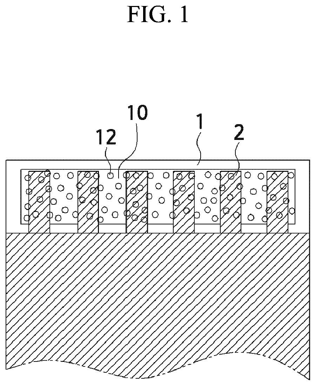

As the number of pixels increases, the number of bumps 2 of a driving IC 1 increases, and a pitch interval between the bumps 2 becomes very narrow as shown in FIG. 1. When the pitch interval and the width of the bumps 2 themselves are reduced as described above, an electric short occurs when conductive particles 12 between the bumps 2 are placed between adjacent patterns. Due to the above technical issues, solutions are concentrated on arranging of conductive particles per unit area to minimize electrical resistance in the pattern while maintaining a certain interval between the conductive particles.

Therefore, in an ACF 10 according to the related art, dispersing of the conductive particles 12 for maintaining constant intervals has been significantly considered while reducing sizes of the conductive particles 12. However, the above direction of developing technology has faced a technical limitation.

In addition, a light-emitting diode (LED) may be used widely in various wavelength bands from ultraviolet ray band to infrared ray band. Since Nichia commercialized nitride light emitting diodes (GaN LEDs), owing to the continuous development in semiconductor thin film technology, process technology, and device technology, GaN-LED has brought a dramatic improvement in performance and reliability, and demands for LEDs have been increasing explosively with the launch of high-luminance and high-power output application products such as mobile phones, TVs, lightings, electronic signs, traffic signs, vehicles, home appliances, etc. from small display devices.

In particular, as a luminous efficiency increased rapidly after year 2005, a huge market of LCD backlight units in the display industry was generated, and it is expected to steadily increase the distribution and development of the LED lights until year 2030 because excellence in energy saving has been proved and price lowering would be accelerated in the lighting industry.

Recently, results of many researches and developments that utilize a degree of freedom in size adjustment, a flexible characteristic, and an effect of selective light-emitting wavelength of the LEDs have been published. LEDs used for lighting mainly have a size of 1000 $\mu$m $\times$ 1000 $\mu$m. When an area of the LED is reduced to 1/100 or less, the size becomes 100 $\mu$m $\times$ 100 $\mu$m that is about a thickness of a human hair, and an LED having a size less than the above is referred to as a micro LED. The micro LED may be mounted on a stretchable substrate, a flexible substrate, and a three-dimensional substrate, and thus may be applied to various fields such as wearable displays, lighting, skin-attached medical devices, semiconductor equipment, autonomous driving sensors, light sources for big data services, etc.

In the micro LED, as the size of an entire micro LED device is reduced to 15 $\mu$m $\times$ 30 $\mu$m, the size of one electrode is reduced to 10 $\mu$m $\times$ 15 $\mu$m or less. Even in the micro LED having the above size, each electrode has to be connected to an electrode pattern formed on a substrate and receive supply of an electric current in order to emit light. Here, the electrodes are electrically connected to the electrode pattern generally by using an ACF.

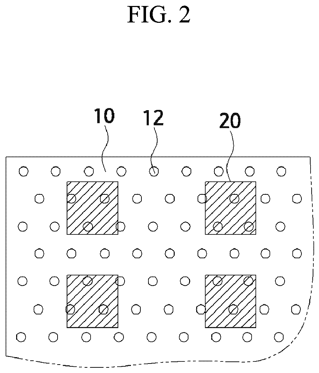

However, as shown in FIG. 2, conductive particles 12 in the ACF 10 according to the related art are uniformly arranged at regular intervals. Here, because each conductive particle 12 has a diameter of about 3 $\mu$m, in a region corresponding to an electrode having a size of 10 $\mu$m $\times$ 15 $\mu$m, five or less conductive particles may be arranged considering sizes and intervals of the conductive particles 12, as shown in FIG. 2. Assuming that the electrodes are connected by about five conductive particles, a ratio of the area wherein the conductive particles are arranged with respect to a total electrode area is 30% or less.

When the electrode and the electrode pattern are connected by such a small number of conductive particles, heat, etc. is generated due to excessive resistance in the process of light emission, and thus, an electric short may occur or a device may be dead.

In addition, in a bonding method using the ACF according to the related art, the bonding process is carried out while supplying the ACF during the bonding process, processing equipment is complicated and an accuracy in the processes degrades.

DETAILED DESCRIPTION OF THE DISCLOSURE

TECHNICAL PROBLEM

The present disclosure provides a conductor bonding method by which a conductor bonding operation is simply and easily carried out because conductive particle patterns and a conductive particle fixing material are provided directly on a lead terminal of an electronic device.

TECHNICAL SOLUTION

A conductor bonding method according to the present disclosure includes 1) placing a first conductive particle fixing material 110 on lead terminals 2 of an electronic device 1 (S100), 2) forming conductive particle patterns by placing conductive particles 120 in a dense state only on regions, in an upper surface of the first conductive particle fixing material 110, corresponding to the regions where the lead terminals 2 are formed in the electronic device(S200), 3) aligning a conductor (FPCB) 3 on the lead terminals 2 of the display panel 1, on which the first conductive particle fixing material and the conductive particle patterns are formed in step 1) and step 2) (S100-S200) (S300), and 4) bonding the aligned conductor 3 to the lead terminals 2 by applying heat or pressure (S400).

The conductor bonding method may further include, after performing step 2) (S200), placing a second conductive particle fixing material 130 that fixes the conductive particle patterns, on the conductive particle pattern (S500).

Each of the first conductive particle fixing material 110 and the second conductive particle fixing material 130 may be one selected from a non-conductive film, a non-conductive tape, and a non-conductive liquid.

Meanwhile, in the embodiment, the conductive particles 120 may have a particle diameter of 10 or less and may include metal particles or polymer particles plated with metal.

Also, in the present disclosure, a protective film 140 may be further coated on the second conductive particle fixing material 130 or the conductive particle pattern, and before performing step 4) (S400), isolating of the protective film may be further performed.

ADVANTAGEOUS EFFECTS OF DISCLOSURE

According to a conductor bonding method of the present disclosure, conductive particles are intensively arranged only in lead terminal patterns and are not arranged in the other regions. Thus, the electric connection may be stably made within the lead terminal patterns, and the electric short generation is fundamentally prevented due to the regions where the conductive particles are not arranged.

In addition, because the conductive particles are fixed and arranged on the lead terminals in the same pattern as that of the lead terminals, the conductor may be accurately and easily bonded through a simple process without additionally supplying a film such as an anisotropic conductive film (ACF), etc.

BRIEF DESCRIPTION OF THE DRAWINGS

FIGS. 1 and 2 are diagrams showing arrangement state of conductive particles in an anisotropic conductive film (ACF) according to the related art.
FIGS. 3 and 4 are diagrams showing processes of a first step (S100) in a conductor bonding method according to the present disclosure.
FIGS. 5 and 6 are diagrams showing processes of a second step (S200) in a conductor bonding method according to the present disclosure.

FIG. 7 is a diagram showing processes of a third step (S300) in a conductor bonding method according to the present disclosure.

FIG. 8 is a diagram showing a process in which a protective film is further coated in the third step (S300) of the conductor bonding method according to the present disclosure.

FIG. 9 is a diagram showing a process in which a protective film is isolated in the third step (S300) of the conductor bonding method according to the present disclosure.

FIG. 10 is a diagram showing processes of a fourth step (S400) in a conductor bonding method according to the present disclosure.

FIGS. 11 and 12 are partially cross-sectional views showing a structure in a bonded state.

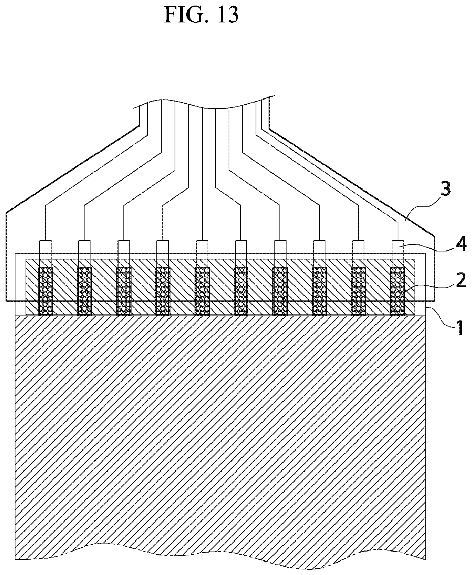

FIG. 13 is a plan view showing a lead terminal and a conductor structure in a bonded state.

FIG. 14 is a flowchart illustrating a conductor bonding method according to the present disclosure.

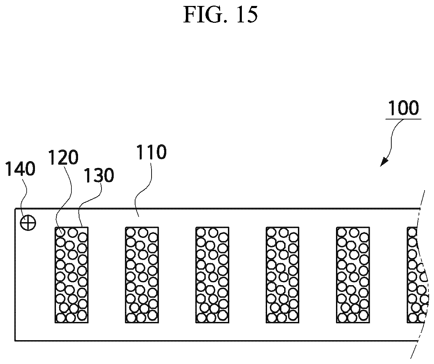

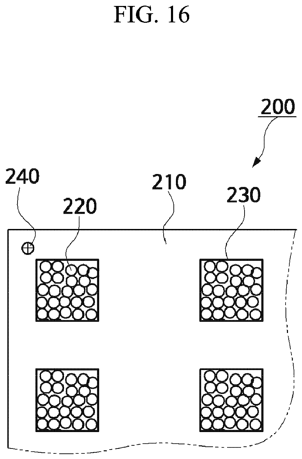

FIGS. 15 and 16 are diagrams showing arrangement states of conductive particles in an ACF according to an embodiment of the present disclosure.

BEST MODE

Hereinafter, one or more embodiments will be described in detail with reference to accompanying drawings.

<Embodiment 1>

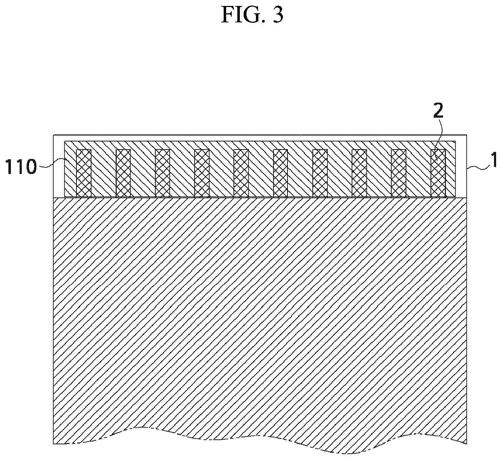

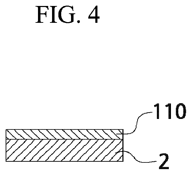

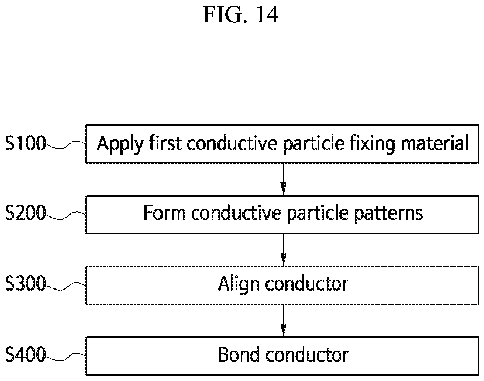

A conductor bonding method according to the embodiment starts with step S100 in which a first conductive particle fixing material is placed, as shown in FIG. 14. In detail, in this operation (S100), as shown in FIGS. 3 and 4, a first conductive particle fixing material 110 is thinly placed on lead terminals 2 of an electronic device 1. In the embodiment, the electronic device 1 may include various electronic devices such as a display apparatus, etc., and the first conductive particle fixing material 110 includes a material that may attach and fix first conductive particles 120 that will be described later on the lead terminals 2. For example, the first conductive particle fixing material 110 may include one selected from a non-conductive film, a non-conductive tape, and a non-conductive liquid.

In the embodiment, the second conductive particle fixing material 110 may be placed in a manner of entirely covering the plurality of lead terminals 2 or in a manner of separately covering each of the lead terminals 2, as shown in FIG. 3.

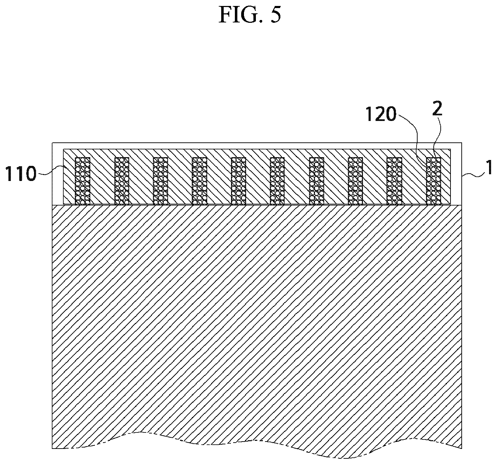

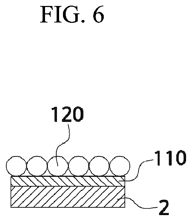

Next, as shown in FIG. 14, an operation of forming a conductive particle pattern (S200) is performed. In this operation (S200), as specifically shown in FIGS. 5 and 6, on an upper surface of the first conductive particle fixing material 110, the conductive particles 120 are placed only on regions corresponding to the regions, where the lead terminals 2 of the electronic device are formed, to be dense to form the conductive particle pattern. That is, the conductive particle pattern is formed by arranging the conductive particles 120 in a dense state to be a pattern matching the shape of the lead terminals 2.

In addition, in the embodiment, 'arranged in a dense state' denotes that the conductive particles 120 are arranged while coming into contact with one another without forming a separation space or while being as close to one another as possible. Therefore, in the conductive particle pattern according to the embodiment, the conductive particles may be arranged without having an empty space other than a gap that is inevitably formed when the conductive particles are in close contact with or adjacent to one another.

In detail, a ratio of an area in which the conductive particles are arranged with respect to a total area of one conductive particle pattern according to the embodiment is 60% or greater.

* Ratio of conductive particle arrangement (%) = area of conductive particle

arrangement/entire pattern area x 100

When the ratio of the conductive area is high as 60% or greater, in a next operation of bonding a conductor 3 (S400), a large number of conductive particles 120 are arranged between the conductor 3 and the lead terminal 2, and the possibility of generating a connection failure is lowered. In addition, even in use after the bonding process, electric energization is carried out over a large area, and then, resistance is reduced and the possibility of generating defects such as heat generation during operation may be reduced.

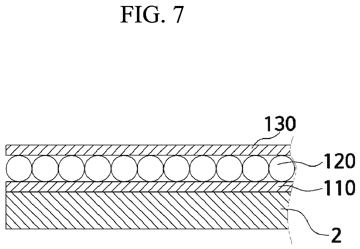

In addition, in the embodiment, as shown in FIG. 7, an operation of placing a second conductive particle fixing material 130 that fixes the conductive particle pattern on the conductive particles (S500) may be further performed after the process of forming the conductive particle pattern (S200).

When the conductor alignment process (S300) and the bonding process (S400) are immediately performed after the conductive particle pattern forming process (S200), the process of placing the second conductive particle fixing material 130 may not be necessary. However, when the electronic device 1 is stored and the conductor alignment process (S300) and the bonding process (S400) are performed or is moved to another space and the conductor alignment process (S300) and the bonding process (S400) are performed after a considerable time amount has passed since the conductive particle pattern is formed, the second conductive particle fixing material 130 is placed once more for protecting and fixing the conductive particle pattern.

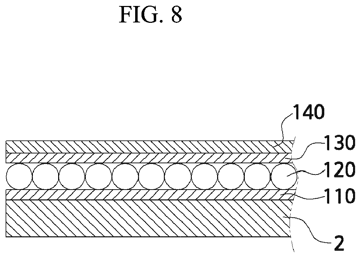

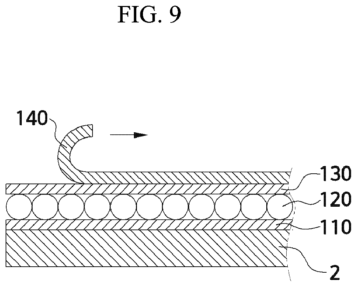

Moreover, as shown in FIG. 8, a protective film 140 may be further coated on the second conductive particle fixing material 130 or the conductive particle pattern, and the protective film 140 is isolated and removed before performing the conductor alignment process (S300) as shown in FIG. 9. Therefore, when the protective film 140 is coated, a protective film isolation process may be further performed before the conductor alignment process (S300).

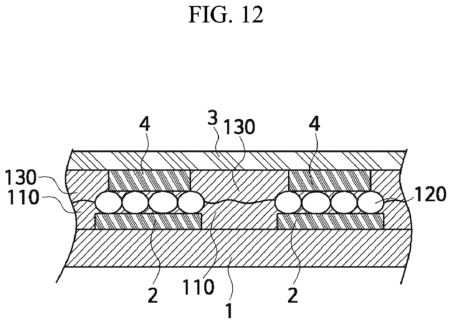

Next, as shown in FIG. 14, the process of aligning the conductor (FPCB) 3 on the lead terminals 2 of the display panel 1, on which the first conductive particle fixing material 110 and the conductive particles 120 are formed is performed (S300). In this process S300, as shown in FIG. 12 in detail, positions of conductor patterns 4 having the same interval as that of the patterns of the lead terminals 2 and the conductive particle patterns are adjusted so that each interval between the conductor patterns 4 coincides with that of the patterns of the lead terminals 2 or the conductive particle patterns.

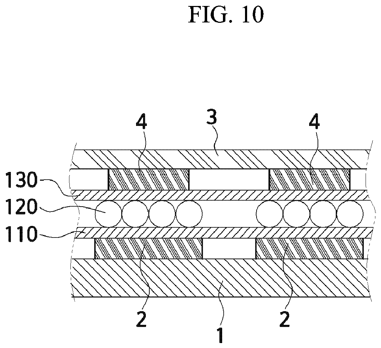

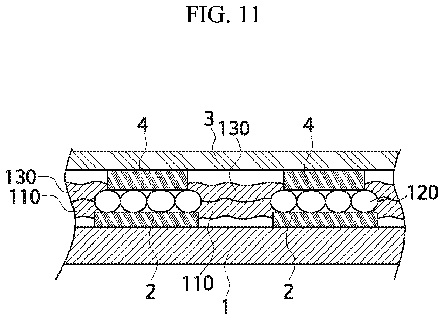

Next, as shown in FIG. 14, the operation of bonding the aligned conductor 3 onto the lead terminals 2 by applying heat or pressure is performed (S400). That is, as shown in FIGS. 10 and 11, the bonding is carried out in the manner of applying both the heat and pressure from upper and lower sides or applying one of the heat and pressure while the conductor patterns 4 and the lead terminals 2 are in close contact with each other. When the bonding is performed as described above, as shown in FIG. 11, the conductive particles 120 between the conductor patterns 4 and the lead terminals 2 allow the both to be electrically connected while coming into contact with the conductor patterns 4 and the lead terminals 2. Here, the conductive particles 120 are slightly pushed and deformed into elliptical shapes, and the first and second conductive particle fixing materials 110 and 120 are pushed to opposite sides to fill empty spaces.

<Embodiment 2>

An anisotropic conductive sheet 100 according to the embodiment has a sheet shape as a whole and includes a sheet 110 and the conductive particles 120, as shown in FIG. 3. The sheet 110 forms the overall exterior of the anisotropic conductive sheet 100 according to the embodiment and includes a plastic resin. The sheet 100 may be formed of a thermosetting epoxy resin or other resins.

The sheet is virtually divided into an area in which the conductive particles 120 are arranged and an area in which the conductive particles 120 are not arranged. Here, the area in which the conductive particles 120 are arranged may be referred to as a conductive pattern 130, and the other area may be referred to as a non-conductive pattern. In addition, the conductive pattern 130 may be changed into various shapes, and the shape and size of the conductive pattern 130 may be precisely the same as those of the electrode pattern formed on the substrate, on which the anisotropic conductive sheet 100 is to be mounted.

In the conductive pattern 130 set as above, the plurality of conductive particles 120 are arranged in close contact with one another as shown in FIG. 3. Here, 'arranged in close contact with one another' denotes that the conductive particles 120 are densely arranged while contacting each other without having a separation space. Therefore, in the anisotropic conductive sheet 100 according to the embodiment, the conductive particles may be arranged without forming an empty space, other than a gap that is inevitably formed while the conductive particles are in close contact with one another, in the conductive pattern 130.

In detail, in the anisotropic conductive sheet 100 according to the embodiment, a ratio of an area in which the conductive particles are arranged with respect to the entire area in one conductive pattern may be 60% or greater.

* Ratio of conductive particle arrangement (%) = area of conductive particle arrangement/entire pattern area x 100

When the conductive area ratio is high as 60% or greater, a large number of conductive particles 120 are arranged between the electrode and the electrode pattern in the process of mounting electrodes 12 and 14 and electrode patterns 22 and 24, and thus, a possibility of generating the connection failure may decrease. In addition, even in use after the mounting operation, the electricity is energized over a large area, and thus, the resistance is lowered and the possibility of generating defects such as heat generation during operation also decrease.

In addition, in the anisotropic conductive sheet 100 according to the embodiment, the conductive particles 120 may be only arranged in the virtual conductive pattern 130, but some may be arranged out of the conductive pattern 130.

Meanwhile, in the embodiment, the conductive particles 120 may have a particle diameter of 10 $\mu$m or less and may include metal particles or polymer particles plated with metal.

In addition, the anisotropic conductive sheet 100 according to the embodiment may further include a mark 130 as shown in FIGS. 3 and 4. The anisotropic conductive sheet 100 according to the embodiment includes the conductive patterns having the same shapes and sizes as those of the electrode patterns formed on the substrate on which the mounting operation is to be performed, and thus, the anisotropic conductive sheet 100 has to be accurately aligned with the substrate in the actual mounting operation.

Therefore, the mark 130 is indicated at an edge or corner of the sheet 110 to be used as a reference point in the aligning operation with the substrate.

BEST MODE

A valve assembly 1 according to the embodiment may further include a pressure maintaining line 710, a housing connection line 720, and a slow pumping valve 730. As shown in FIG. 9, the pressure maintaining line 710 is installed through a housing body 110 and is a gas passing line having one end opened toward a chamber-side exhaust line 10a of an exhaust line 10 and the other end opened toward a pump-side exhaust line 10b of the exhaust line. In addition, the housing connection line 720 is a gas passing line that is in communication with a middle part of the pressure maintaining line 710 and in communication with an inner space of the valve housing 100. An internal pressure of the valve housing 110 and a pressure of the exhaust line 10 may be always adjusted to be the same by the pressure maintaining line 710 and the housing connection line 720.

In addition, the slow pumping valve 730 is installed in the pressure maintaining line 710 and is an element controlling the pressure maintaining line 710 as shown in FIG. 9. Before changing a shut-off state of the valve 200 to a communication state, the slow pumping valve 730 is switched from the shut-off state to an open state, and a process in which the internal pressure of the housing body 110 becomes equal to the pressure of the exhaust line is carried out. Then, when the valve 200 is switched to the open state, failures, defects, etc. due to the pressure difference in the valve housing 100 may be prevented.

INDUSTRIAL APPLICABILITY

According to the anisotropic conductive sheet of the present disclosure, the conductive particles are intensively arranged only in certain patterns and are not arranged in the other regions. Thus, the electric connection may be stably made within the certain patterns, and the electric short generation is fundamentally prevented due to the regions where the conductive particles are not arranged.

In particular, because the conductive particles are intensively arranged in the certain patterns according to the present disclosure, the occurrence of electric short may be prevented by utilizing the regions where the conductive particles are not arranged, without reducing the size of the conductive particles. Thus, handling of the conductive particles becomes easy during the manufacturing process of the anisotropic conductive sheet.

**Claims**

1. A conductor bonding method comprising:

   1) placing a first conductive particle fixing material 110 on lead terminals 2 of an electronic device 1 (S100);
   2) forming conductive particle patterns by placing conductive particles 120 in a dense state only on regions, in an upper surface of the first conductive particle fixing material 110, corresponding to the regions where the lead terminals 2 are formed in the electronic device(S200);
   3) aligning a conductor (FPCB) 3 on the lead terminals 2 of the display panel 1, on which the first conductive particle fixing material and the conductive particle patterns are formed in step 1) and step 2) (S100-S200) (S300); and
   4) bonding the aligned conductor 3 to the lead terminals 2 by applying heat or pressure (S400).

2. The conductor bonding method of claim 1, further comprising, after performing step 2) (S200),
   placing a second conductive particle fixing material 130 that fixes the conductive particle patterns, on the conductive particle pattern (S500).

3. The conductor bonding method of claim 2, wherein each of the first conductive particle fixing material 110 and the second conductive particle fixing material 130 is one selected from a non-conductive film, a non-conductive tape, and a non-conductive liquid.

4. The conductor bonding method of claim 1, wherein the conductive particles 120 each have a diameter of 10 or less and include metal particles or polymer particles plated with metal.

5. The conductor bonding method of claim 2, wherein a protective film 140 is further coated on the second conductive particle fixing material 130 or the conductive particle pattern, and before performing step 4) (S400), isolating of the protective film is further performed.

FIG. 1

FIG. 2

FIG. 3

FIG. 4

## FIG. 5

FIG. 6

FIG. 7

FIG. 8

FIG. 9

## FIG. 10

FIG. 11

FIG. 12

FIG. 13

FIG. 14

S100 — Apply first conductive particle fixing material

S200 — Form conductive particle patterns

S300 — Align conductor

S400 — Bond conductor

FIG. 15

FIG. 16

## INTERNATIONAL SEARCH REPORT

| International application No. |
|---|
| **PCT/KR2020/007319** |

**A. CLASSIFICATION OF SUBJECT MATTER**

**H01L 23/00**(2006.01)i

According to International Patent Classification (IPC) or to both national classification and IPC

**B. FIELDS SEARCHED**

Minimum documentation searched (classification system followed by classification symbols)

H01L 23/00(2006.01); H01B 5/16(2006.01); H01J 11/44(2012.01); H01J 11/46(2012.01); H01L 21/60(2006.01); H01L 23/48(2006.01); H01R 11/01(2006.01); H05K 3/32(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 본딩(bonding), 단자(terminal), 입자(particle), 이방성-전도필름(anisotropic-conductive-film)

**C. DOCUMENTS CONSIDERED TO BE RELEVANT**

| Category* | Citation of document, with indication, where appropriate, of the relevant passages | Relevant to claim No. |
|---|---|---|
| X | KR 10-2011-0137158 A (KOREA INSTITUTE OF INDUSTRIAL TECHNOLOGY) 22 December 2011 (2011-12-22)<br>See paragraphs [0065]-[0103]; claims 1 and 6; and figures 6-11. | 1-3 |
| Y | | 4-5 |
| Y | KR 10-2014-0100511 A (ASAHI KASEI E-MATERIALS CORPORATION) 14 August 2014 (2014-08-14)<br>See paragraphs [0123]-[0124]; claim 8; and figures 5-6. | 4-5 |
| A | US 2017-0062379 A1 (APPLE INC.) 02 March 2017 (2017-03-02)<br>See paragraphs [0038]-[0039]; and figures 3A-3B. | 1-5 |
| A | KR 10-2017-0076783 A (DEXERIALS CORPORATION) 04 July 2017 (2017-07-04)<br>See claim 1; and figures 1a-1c. | 1-5 |

☑ Further documents are listed in the continuation of Box C.    ☑ See patent family annex.

| * | Special categories of cited documents: |
|---|---|
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **05 February 2021** | **08 February 2021** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2019)

## INTERNATIONAL SEARCH REPORT

International application No.

**PCT/KR2020/007319**

**C.    DOCUMENTS CONSIDERED TO BE RELEVANT**

| Category* | Citation of document, with indication, where appropriate, of the relevant passages | Relevant to claim No. |
|---|---|---|
| A | KR 10-2007-0038771 A (LG ELECTRONICS INC.) 11 April 2007 (2007-04-11) See paragraphs [0042]-[0048]; and figures 4a-4e. | 1-5 |

Form PCT/ISA/210 (second sheet) (July 2019)

INTERNATIONAL SEARCH REPORT
Information on patent family members

International application No.

**PCT/KR2020/007319**

| Patent document cited in search report | | | Publication date (day/month/year) | Patent family member(s) | | | Publication date (day/month/year) |
|---|---|---|---|---|---|---|---|
| KR | 10-2011-0137158 | A | 22 December 2011 | KR | 10-1156177 | B1 | 18 June 2012 |
| KR | 10-2014-0100511 | A | 14 August 2014 | CN | 103988289 | A | 13 August 2014 |
| | | | | JP | 2015-159333 | A | 03 September 2015 |
| | | | | WO | 2013-089199 | A1 | 20 June 2013 |
| US | 2017-0062379 | A1 | 02 March 2017 | US | 9653425 | B2 | 16 May 2017 |
| KR | 10-2017-0076783 | A | 04 July 2017 | CN | 107004974 | A | 01 August 2017 |
| | | | | CN | 107004974 | B | 01 September 2020 |
| | | | | JP | 2016-119306 | A | 30 June 2016 |
| | | | | JP | 2020-177916 | A | 29 October 2020 |
| | | | | JP | 6759578 | B2 | 23 September 2020 |
| | | | | KR | 10-1929697 | B1 | 14 December 2018 |
| | | | | US | 2017-0352967 | A1 | 07 December 2017 |
| | | | | US | 9991614 | B2 | 05 June 2018 |
| | | | | WO | 2016-104463 | A1 | 30 June 2016 |
| KR | 10-2007-0038771 | A | 11 April 2007 | CN | 1945665 | A | 11 April 2007 |
| | | | | EP | 1772889 | A2 | 11 April 2007 |
| | | | | EP | 1772889 | A3 | 26 November 2008 |
| | | | | US | 2007-0080359 | A1 | 12 April 2007 |
| | | | | US | 7573198 | B2 | 11 August 2009 |

Form PCT/ISA/210 (patent family annex) (July 2019)